(19) Europäisches Patentamt
European Patent Office
Office européen des brevets

(11) EP 3 422 496 A1

(12) **EUROPEAN PATENT APPLICATION**

(43) Date of publication:
**02.01.2019 Bulletin 2019/01**

(21) Application number: **18165352.8**

(22) Date of filing: **31.03.2018**

(51) Int Cl.:
***H01S 5/02*** *(2006.01)*
***H01S 5/183*** *(2006.01)*
***H01S 5/343*** *(2006.01)*
***H01S 5/42*** *(2006.01)*
***H01S 5/20*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.06.2017 US 201762524198 P**
**20.07.2017 US 201715655470**

(71) Applicant: **Lumentum Operations LLC**
**Milpitas, California 95035 (US)**

(72) Inventors:
- **HEGBLOM, Eric R.**
**Milpitas, CA California 95035 (US)**
- **TASHIMA, Mark M.**
**Milpitas, CA California 95035 (US)**

(74) Representative: **Murgitroyd & Company**
**Scotland House**
**165-169 Scotland Street**
**Glasgow G5 8PL (GB)**

# (54) VERTICAL-CAVITY SURFACE-EMITTING LASER THIN WAFER BOWING CONTROL

(57) A vertical-cavity surface-emitting laser (VCSEL) wafer, comprising may comprise a substrate layer and epitaxial layers on the substrate layer. The epitaxial layers may include an active region, a first mirror, and a second mirror. The active region may be between the first mirror and the second mirror. The second mirror may include a set of reflector pairs, each reflector pair including a respective strain compensating low-index layer associated with controlling bowing of the VCSEL wafer after thinning.

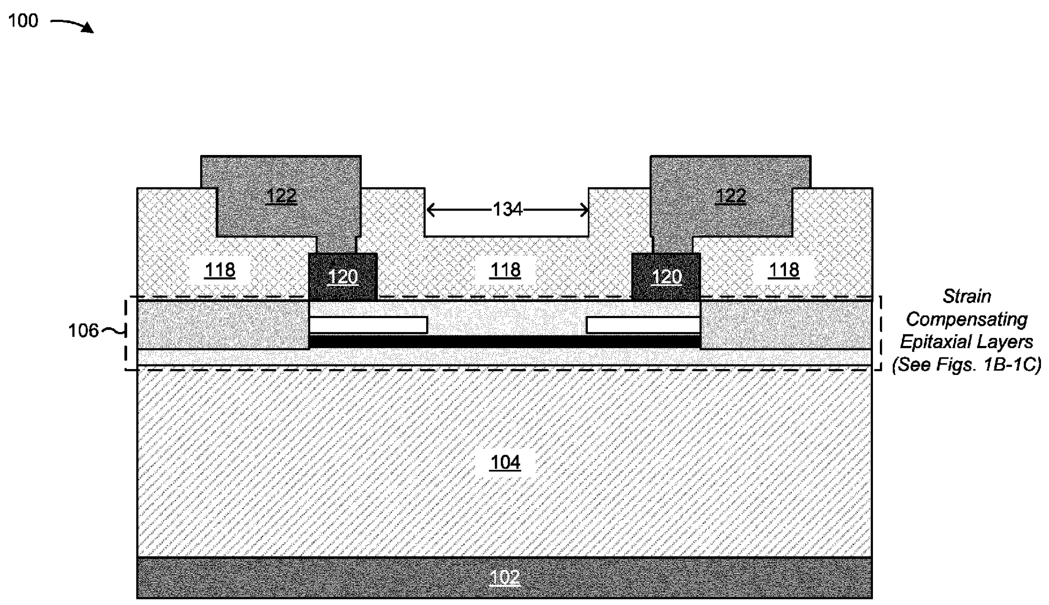


FIG. 1A

EP 3 422 496 A1

## Description

### TECHNICAL FIELD

The present disclosure relates generally to vertical-cavity surface-emitting lasers (VCSELs) and, more particularly, to bowing control for thin VCSEL wafers.

### BACKGROUND

A vertical-emitting device, such as a VCSEL, is a laser in which a laser beam is emitted in a direction perpendicular to a surface of a substrate (e.g., vertically from a surface of a semiconductor wafer). A typical VCSEL includes epitaxial layers grown on a substrate. The epitaxial layers may include, for example, a pair of reflectors (e.g., a pair of distributed Bragg reflectors (DBRs)), an active region, an oxidation layer, and/or the like. Other layers may be formed on or above the epitaxial layers, such as one or more dielectric layers, metal layers, and/or the like.

### SUMMARY

According to some possible implementations, a VCSEL wafer may include: a substrate layer; and epitaxial layers on the substrate layer, wherein the epitaxial layers may include an active region, a first mirror, and a second mirror, wherein the active region may be between the first mirror and the second mirror, and wherein the second mirror includes a set of reflector pairs, each reflector pair including a respective strain compensating low-index layer associated with controlling bowing of the VCSEL wafer after thinning.

According to some possible implementations, a surface emitting laser may include: a substrate layer; and epitaxial layers on the substrate layer, wherein the epitaxial layers may include an active region, a first mirror, and a second mirror, wherein the active region may be between the first mirror and the second mirror, and wherein the second mirror includes a set of reflector pairs, each reflector pair including a respective strain compensating layer associated with controlling bowing of a wafer, including the surface emitting laser, after thinning.

According to some possible implementations, a VCSEL may include a set of epitaxial layers comprising: an active region; a first mirror on a first side of the active region; and a second mirror on a second side of the active region, wherein the second side of the active region may be opposite to the first side of the active region, and wherein the second mirror may include a set of strain compensating layers associated with controlling bowing of a wafer, including the VCSEL, after thinning of the wafer.

### BRIEF DESCRIPTION OF THE DRAWINGS

Figs. 1A-1C are diagrams depicting cross-sectionals view associated with an example VCSEL design, associated with controlling thinned VCSEL wafer bowing, that includes strain compensating epitaxial layers;

Fig. 1B is a diagram depicting a cross-sectional view of example epitaxial layers of example VCSELs, described herein, including additional features found in finished VCSELs; and

Fig. 2 is a diagram depicting a cross-sectional view of an epitaxial layer of a conventional VCSEL design.

### DETAILED DESCRIPTION

The following detailed description of example implementations refers to the accompanying drawings. The same reference numbers in different drawings may identify the same or similar elements. The implementations described below are merely examples and are not intended to limit the implementations to the precise forms disclosed. Instead, the implementations were selected for description to enable one of ordinary skill in the art to practice the implementations. In the following detailed description, the term VCSEL is used synonymously for a single VCSEL or an array of VCSELs unless stated otherwise. Furthermore, while layers are described as being associated with or used by a single VCSEL, in some implementations, a VCSEL layer may be shared by VCSELs in a VCSEL array. For example, while anode layers and cathode layers are described as being associated with or used by a single VCSEL (e.g., such that each VCSEL has an anode layer and a cathode layer that is separate from those of another adjacent VCSEL), in some implementations, two or more VCSELs of a VCSEL array (e.g., within a die formed on a VCSEL wafer) may share a common anode layer or a common cathode layer.

During fabrication, a VCSEL wafer (e.g., a wafer including multiple individual VCSELs) may be thinned in order to, for example, facilitate die separation. For example, the VCSEL wafer may be thinned such that the VCSEL wafer has a thickness in a range from approximately 70 micrometers ($\mu$m) to approximately 300$\mu$m. In contrast, a "thick" wafer (e.g., with a thickness from approximately 400$\mu$m to approximately 700$\mu$m thick) used during most of the fabrication process may bow less for the same amount of top and bottom side strain.

However, a thinned VCSEL wafer may experience bowing due to strain in one or more layers of the VCSEL wafer, such as epitaxial layers, dielectric layers, metal layers, and/or the like. For example, when fabricated using conventional materials (e.g., Aluminum Gallium Arsenide (AlGaAs) epitaxial layers, Silicon Nitride (SiNx) dielectric layer(s), a Titanium (Ti)/Platinum (Pt)/Gold (Au) anode, a Gallium Arsenide (GaAs) substrate, a Gold-Germanium (Au-Ge) backside cathode, and/or the like), a VCSEL wafer with a diameter of 6 inches (e.g., approximately 15.24 centimeters (cm)) may bow one or more centimeters after thinning to approximately 100μm. Such bowing may cause the VCSEL wafer to be fragile or difficult to handle, transport, or test without a risk of breakage.

A VCSEL wafer presents a particular challenge since epitaxial layers (e.g., composed of AlGaAs) of the typical VCSEL wafer are thicker and have a higher average Al mole fraction than some other types of AlGaAs/GaAs wafers, such as those for edge emitting lasers or field-effect transistors. For example, epitaxial layers of the typical VCSEL wafer (e.g., AlGaAs epitaxial layers grown on a GaAs substrate) may have a thickness of approximately 10μm and an average Al mole fraction of approximately 50% or higher (e.g., the Al mole fraction may be greater than 70% for low-index layers among the epitaxial layers), while epitaxial layers of some other types of AlGaAs/GaAs wafers may have a thickness of a few micrometers and an average Al mole fraction of less than 50%. Since AlGaAs, when grown on a GaAs substrate, is compressively stressed, the epitaxial layers contribute most of the integrated strain in the VCSEL wafer and, thus, cause most of the VCSEL wafer bowing. As such, the integrated strain, and the resultant wafer bowing, may be of a particular concern for a VCSEL wafer.

If AlGaAs substrates were readily available, and if high quality epitaxial layers could be grown upon such AlGaAs substrates, then such strain and bowing may not be an issue. However, AlGaAs substrates are not readily available (e.g., commercially) and, even if such substrates were available, the presence of aluminum on a surface of the AlGaAs substrate would increase complexity associated with growing the epitaxial layers (e.g., due to formation of a thin surface oxide on the AlGaAs substrate surface that would result upon exposure of the AlGaAs substrate surface to air).

Further, the VCSEL wafer bowing issue could potentially be resolved by removing the GaAs substrate from the VCSEL wafer (e.g., with selective etching). However, removal of the GaAs substrate would result in a significantly more fragile AlGaAs VCSEL wafer with a thickness of approximately 10μm.

Some implementations described herein provide a VCSEL design for controlling (e.g., reducing, compensating for, and/or the like) wafer bowing of a thinned VCSEL wafer, thereby reducing fragility of the VCSEL wafer and/or making the thinned VCSEL wafer easier to handle, transport, test, and/or the like, with a reduced risk of breakage (e.g., as compared to a conventional VCSEL wafer). Notably, the wafer bowing addressed by the designs described herein is bowing experienced by a thinned (e.g., finished) VCSEL wafer, rather than bowing experienced during intermediate steps of VCSEL wafer fabrication (e.g., experienced when the substrate has a thickness that is greater than approximately 300μm).

Further, while the designs described herein are described in the context of VCSELs, these designs may be applied to another type of emitter and/or optical device, such as a light emitting diode (LED), or another type of vertical emitting (e.g., top emitting or bottom emitting) optical device. Additionally, the designs described herein may apply to VCSELs, other types of emitters, and/or other types of optical devices of any wavelength, power level, emission profile or the like. In other words, the designs described herein are not particular to a VCSELs, other types of emitters, or optical devices with a given performance characteristic.

Figs. 1A-1C are diagrams depicting cross-sectional views of an example VCSEL design, associated with controlling thinned VCSEL wafer bowing, that includes strain compensating epitaxial layers.

As shown in Fig. 1A, the example VCSEL design provides a VCSEL 100 that includes a backside cathode layer 102, a substrate layer 104, epitaxial layers 106 (e.g., shown in further detail in Figs. 1B and 1C), a dielectric passivation/mirror layer 118, an ohmic-contact metal layer 120, and an anode layer 122. In some implementations, VCSEL 100 (e.g., a wafer of VCSELs 100) may be fabricated using a series of procedures. For example, one or more layers of VCSEL 100 may be fabricated using one or more growth procedures, one or more deposition procedures, one or more etching procedures, one or more oxidation procedures, one or more implantation procedures, one or more metallization procedures, and/or the like.

Backside cathode layer 102 includes a layer that makes electrical contact with substrate layer 104 (e.g., a backside of substrate layer 104, shown as a bottom side of substrate layer 104 in Fig. 1A). For example, backside cathode layer 102 may include an annealed metallization layer, such as a Gold-Germanium-Nickel (AuGeNi) layer, a Palladium-Germanium-Gold (PdGeAu) layer, and/or the like.

Substrate layer 104 includes a substrate upon which epitaxial layers 106 of VCSEL 100 are grown. In some implementations, substrate layer maybe formed from a semiconductor material, such as GaAs, Indium Phosphide (InP), and/or another type of semiconductor material.

Epitaxial layers 106 include a set of layers grown on substrate layer 104 and/or layers, formed from one or more layers grown on substrate layer 104, that include features of a finished VCSEL 100. For example, epitaxial layers 106 may include an optical resonator including pair of reflectors (e.g., a pair of Distributed Bragg Reflectors (DBRs), a pair of dielectric mirrors, and/or the like) and an active gain medium (herein referred to as an active region), one or more layers used to form one or more apertures (e.g., for optical and/or electrical confinement), and/or the like. In some implementations, epitaxial layers 106 may include a set of AlGaAs layers grown on substrate layer 104 (e.g., a GaAs substrate). In some implementations, a subset of layers of epitaxial layers 106 may be strain compensating layers associated with controlling bowing of a wafer of VCSELs 100. For example, a subset of layers of epitaxial layers 106 may include a particular percentage of Phosphorous (P) (e.g., in order to form a subset of AlGaAsP layers) that control strain associated with epitaxial layers 106, as described in further detail below. In some implementations, epitaxial layers 106 may include layers grown on substrate layer 104 using a Metal-Organic Chemical Vapor deposition (MOCVD) technique, a Molecular beam Epitaxy (MBE) technique, and/or the like. In some implementations, epitaxial layers 106 may have a thickness in a range from approximately 7μm to approximately 16μm, such as 8μm or 10μm.

As noted in Fig. 1A, and with reference to Fig. 1B, epitaxial layers 106 of VCSEL may include a bottom mirror 108, an active region 110, an oxidation layer 112 (defining an oxidation aperture 132), a top mirror 114, and isolation material 116.

Bottom mirror 108 includes a bottom reflector of an optical resonator of VCSEL 100. For example, bottom mirror 108 may include a distributed Bragg reflector (DBR), a dielectric mirror, and/or the like. In some implementations, bottom mirror 108 may have a thickness in a range from approximately 3.5μm to approximately 9μm, such as 5μm. In some implementations, bottom mirror 108 may be an n-doped reflector. In some implementations, bottom mirror 108 may include one or more high-index layers, low-index layers, graded layers, strain compensating layers, and/or the like. Additional details regarding bottom mirror 108 are described below with regard to Fig. 1C.

Active region 110 includes one or more layers where electrons and holes recombine to emit light and define the emission wavelength range of VCSEL 100. For example, active region 110 may include one or more quantum wells. The active region 110 also includes cavity spacer layers between bottom mirror 108 and top mirror 114. The optical thickness of active region 110 (including cavity spacer layers) and optical thickness of bottom mirror 108 and top mirror 114 define a resonant cavity wavelength of VCSEL 100, which is designed within the emission wavelength range of active region 110 to enable lasing. In some implementations, active region 110 may have a thickness in a range from approximately 0.15μm to approximately 0.5μm, such as 0.3μm. In some implementations, active region 110 may be formed from GaAs, Indium-Gallium-Arsenide (InGaAs), Gallium-Indium-Phosphide (GaInP), Indium-Gallium-Arsenic-Phosphide (InGaAsP), Indium-Gallium-Arsenic-Nitride (InGaAsN), and/or the like.

Oxidation layer 112 includes an oxide layer that provides optical and electrical confinement. In some implementations, oxidation layer 112 may be formed as a result of oxidation of one or more epitaxial layers. For example, oxidation layer 112 may be an Aluminum Oxide ($Al_2O_3$) layer formed as a result of oxidation of an epitaxial layer (e.g., a AlGaAs layer, an Aluminum Arsenide (AlAs) layer, and/or the like). In some implementations, oxidation layer 112 may have a thickness in a range from approximately 0.007μm to approximately 0.400μm, such as 0.020μm. In some implementations, oxidation trenches (not shown) etched around VCSEL 100 may allow steam to access the epitaxial layer from which oxidation layer 112 is formed. As shown, oxidation layer 112 may define oxidation aperture 132 (e.g., an optically active aperture). In some implementations, oxidation aperture 132 may be a non-circular shape, but a circle of approximately the same area may have a diameter in a range from approximately 1μm to approximately 300μm, such as 8μm.

Top mirror 114 includes a top reflector layer of VCSEL 100. For example, top mirror 114 may include a DBR, a dielectric mirror, and/or the like. In some implementations, top mirror 114 may have a thickness in a range from approximately 2μm to approximately 6μm, such as 4μm. In some implementations, top mirror 114 may be a p-doped reflector. In some implementations, top mirror 114 may include one or more high-index layers, low-index layers, graded layers, and/or the like. Additional details regarding top mirror 114 are described below with regard to Fig. 1C.

Isolation material 116 includes a material that provides electrical isolation of VCSEL 100. For example, isolation material 116 may include an ion implanted material, such as a Hydrogen implanted material or a Hydrogen/Proton implanted material (e.g., one or more Hydrogen implanted or Hydrogen/Proton implanted epitaxial layers). In some implementations, isolation material 116 may be formed by applying an ion implanting process to one or more epitaxial layers grown on substrate layer 104. In some implementations, isolation material 116 may have a thickness in a range from approximately 3μm to approximately 7μm, such as 5μm.

Returning to Fig. 1A, dielectric passivation/mirror layer 118 includes a layer that acts as a protective passivation layer and/or that acts as an additional DBR. For example, dielectric passivation mirror layer may include one or more sub-layers (e.g., a Silicon Dioxide ($SiO_2$) layer, a SiNx layer, and/or the like) deposited (e.g., via chemical vapor deposition) on one or more epitaxial layers 106 of VCSEL 100 (e.g., isolation material 116 and top mirror 114). In some implementations, dielectric passivation/mirror layer 118 may have a thickness in a range from approximately 0.25μm to approximately 2.5μm, such as 1.5μm. As shown, a portion of dielectric passivation/mirror layer 118 over oxidation aperture 132 may form an optical aperture 134 (e.g., an aperture via which light may be emitted). In some implementations, optical aperture 134 may be defined by the diameter of oxidation aperture 132, and an additional aperture may be formed for mode selectivity. In some implementations, optical aperture 134 may have a diameter in arrange from approximately 2μm to approximately 300μm, such as 15μm As further shown, dielectric passivation/mirror layer 118 may include one or more openings (e.g., formed by etching) that provide electrical access to ohmic-contact metal layer 120.

Ohmic-contact metal layer 120 includes a layer that makes electrical contact via which current may flow. Ohmic-contact metal layer 120 may include an annealed metallization layer. For example, ohmic-contact metal layer 120 may include a Chromium-Gold (CrAu) layer, a Gold-Zinc layer (AuZn), a Titanium-Platinum-Gold (TiPtAu) layer, or the like, via which electrical current may flow. In some implementations, ohmic-contact metal layer 120 may have a thickness in a range from approximately 0.03$\mu$m to approximately 0.3$\mu$m, such as 0.2$\mu$m.

Anode layer 122 includes one or more layers for making electrical contact with ohmic-contact metal layer 120 (e.g., through vias in dielectric passivation/mirror layer 118). In some implementations, anode layer 122 may have a thickness in a range from approximately 0.2$\mu$m to approximately 5.0$\mu$m, such as 2.0$\mu$m.

As described above, conventional epitaxial layers (e.g., AlGaAs layers) may be compressively strained (e.g., when grown on a GaAs substrate). Thus, one possible solution to control thinned wafer bowing may be to design a VCSEL such that the integrated stress-thickness-product for layers on the epitaxial side of substrate layer 104 and layers on the non-epitaxial side of substrate layer 104 (e.g., the side of substrate layer 104 opposite from that on which epitaxial layers 106 are grown, shown as a bottom side of substrate layer 104 in Fig. 1A) are approximately equal. This condition may be expressed as $F_T = F_B$, respectively, where $F_T$ represents the integrated stress-thickness product for the layers on the epitaxial side and $F_B$ represents the integrated stress-thickness product for the layers on the non-epitaxial side. $F_T$ and $F_B$ may be calculated as:

$$F_T = \sum\nolimits_{\text{Top Films}} \sigma_j t_j$$

$$F_B = \sum\nolimits_{\text{Bottom Films}} \sigma_j t_j$$

where $\sigma_j$ and $t_j$ are the stress and thickness of a $j$th layer. In a typical VCSEL design without stress compensation, $|F_B|$ is expected to be much lower than $|F_T|$. Thus, control of thinned wafer bowing may be achieved by the design of epitaxial layers 106 such that the integrated stress-thickness product, $F_T$, on the epitaxial side of substrate layer 104 is removed and/or reduced (e.g., as compared to a conventional epitaxial layer design).

Fig. 1C is a diagram of a cross-section of example epitaxial layers 106 associated with controlling thinned wafer bowing. As shown in Fig. 1C, epitaxial layers 106 may include low-index layers 136, high-index layers 138, graded regions 140, and strain compensating low-index layers 142.

Low-index layer 136 includes an epitaxial layer with a relatively low refractive index (e.g., as compared to high-index layer 138). As shown in Fig. 1C, bottom mirror 108 and top mirror 114 may include one or more low-index layers 136. In some implementations, low-index layer 136 may be an AlGaAs layer with a relatively high Al content (e.g., as compared to high-index layer 138). For example, low-index layer 136 may be an $Al_xGa_{(1-x)}As$ layer, where x is greater than or equal to approximately 0.5 (e.g., low-index layer 136 may include an Al mole fraction of at least 50% Al). In some implementations, a thickness of a given low-index layer 136 may be in a range from approximately 0.040$\mu$m to approximately 0.115$\mu$m, such as 0.05$\mu$m. As shown in Fig. 1C, a given low-index layer 136 may be separated from another layer (e.g., a high-index layer 138, active region 110, and/or the like), by graded regions 140. Graded region 140 includes an epitaxial layer in which a material composition transitions (e.g., within the graded region) from a material similar to that of low-index layer 136/strain compensating low-index layer 142 to a material similar to that of high-index layer 138. For example, graded region 140 may have a continuous change in the mole fraction of Al and/or P) from that of a material composition used in low-index layer 136/strain compensating low-index layer 142 to that of a high-index layer138. Grading the material composition between low-index and high-index layers reduces electrical resistance of the DBR (e.g., bottom mirror 108, top mirror 114). However, in some designs, electrical contact may be made within the DBR pairs and, for some pairs, grading may not be necessary.

Strain compensating low-index layer 142 includes an epitaxial layer with a relatively low refractive index (e.g., as compared to high-index layer 138) that compensates for compressive strain in epitaxial layers 106. In some implementations, such compensation may be achieved by forming all low-index layers as strain compensating low-index layer 142 such that these layers are unstrained, thereby reducing compressive strain in epitaxial layers 106. For example, in the case of a GaAs substrate layer 104 and AlGaAs-based epitaxial layers 106, strain compensating low-index layer 142 may include a P mole fraction that is less than or equal to approximately 10% (e.g., approximately 3%) in order to cause the lattice constant, associated with epitaxial layers 106, to match that of substrate layer 104. In some implementations, excluding P in one or more low Al content (i.e., low-index) layers of epitaxial layers 106 may allow for higher mobility and thermal conductivity in one or more low Al content layers (e.g., one or more high-index layers 138) and/or may reduce a number of calibrations associated with VCSEL 100 (e.g., as compared to including P in both high-index and low-index layers). For example, the Al mole fraction and the P mole fraction in AlGaAsP may affect strain and bandgap of the material. Therefore, it may be difficult to calibrate the Al mole fraction and the P mole fraction simultaneously. Typically, a calibration sample $Al_xGa_{(1-x)}As$ needs to be grown without P in order to calibrate the Al mole fraction x for given growth conditions, and then a sample with the same Al mole fraction may be grown with P ($Al_xG_{(1-x)}As_{(1-y)}P_y$) in order to calibrate the P mole fraction. Because the high-index and low-index layers have different Al mole fractions, and may be grown with different As overpressure, it is simpler to require only one type of layer (e.g., a low-index layer 136/142) to contain P.

In some implementations, strain compensating low-index layer 142 may be an AlGaAs layer with a relatively high Al content (e.g., similar to that of low-index layer 136 described above). In some implementations, a thickness of a given strain compensating low-index layer 142 may be in a range from approximately 0.040$\mu$m to approximately 0.115$\mu$m, such as 0.05$\mu$m. In some implementations, strain compensating low-index layer 142 and low-index layer 136 with the same Al mole fraction may have slightly different thicknesses in order to, for example, compensate for different refractive indices (e.g., by a few tenths of a percent) of these layers caused by the additional P. As shown in Fig. 1C, a given strain compensating low-index layer 142 may be separated from another layer (e.g., a high-index layer 138, active region 110, and/or the like), by graded regions 140.

High-index layer 138 includes an epitaxial layer with a relatively high refractive index (e.g., as compared to low-index layer 136). As shown in Fig. 1C, bottom mirror 108 and top mirror 114 may include one or more high-index layers 138. In some implementations, high-index layer 138 may be an AlGaAs layer with a relatively low Al mole fraction (e.g., as compared to low-index layer 136). For example, high-index layer 138 may be $Al_x$-$Ga_{(1-x)}As$ layer, where x is less than approximately 0.5 (e.g., high-index layer 138 may include an Al mole fraction that is less than 50%). In some implementations, a thickness of a given high-index layer 138 may be in a range from approximately 0.025$\mu$m to approximately 0.1$\mu$m, such as 0.04$\mu$m. As shown in Fig. 1C, a given high-index layer 138 may be separated from another layer (e.g., a low-index layer 136, a strain compensating low-index layer 142, and/or the like), by graded regions 140.

In some implementations, as illustrated in Fig. 1C, layers of bottom mirror 108 and top mirror 114 may be arranged to form reflector pairs. For example, a reflector pair in bottom mirror 108 or top mirror 114 may include a low-index layer 136, a high-index layer 138, and two graded regions 140 (e.g., a graded region between the low-index layer 136 and the high-index layer 138, and a graded region that separates the reflector pair from an adjacent reflector pair). As another example, a reflector pair in bottom mirror 108 may include a strain compensating low-index layer 142, a high-index layer 138, and two graded regions 140 (e.g., a graded region between the strain compensating low-index layer 142 and the high-index layer 138, and a graded region that separates the reflector pair from an adjacent reflector pair).

In some implementations, strain compensating low-index layers 142 may be included in an n-doped reflector of VCSEL 100 only. In these implementations, strain compensating low-index layers 142 may have tensile strain in order to compensate for the compressive strain of other compressively strained layers. For example, with respect to Fig. 1C, if bottom mirror 108 is an n-doped reflector and top mirror 114 is a p-doped reflector, then one or more strain compensating low-index layers 142 may be included in bottom mirror 108 only. In some implementations, excluding strain compensating low-index layers 142 from the p-doped reflector may prevent degradation in performance and/or calibration of VCSEL 100 (e.g., as compared to including strain compensating low-index layers 142 in the p-doped reflector). For example, the p-doped reflector (e.g., top mirror 114) is typically doped with Carbon. However, Carbon may sit on the As (or P) site and may be affected by group V (e.g., As or P) overpressure during growth. As such, with the addition of Phosphorous, the doping of the p-doped reflector may become complex to calibrate. Here, the p-doped reflector is generally higher resistance and is more critical to dope optimally than the n-doped reflector, which generally has lower resistance. Therefore, in some implementations, strain compensating low-index layers 142 may be included only in the n-doped reflector of VCSEL 100 (e.g., bottom mirror 108).

In some implementations, as shown in Fig. 1C, VCSEL 100 may include N reflector pairs ($N \geq 1$), each including a strain compensating low-index layer 142, that are separated from active region 110 by M ($M \geq 1$) reflectors pairs including low-index layers 136. In these implementations, strain compensating low-index layers 142 may have tensile strain in order to compensate for the compressive strain of other compressively strained layers. Control of a lasing wavelength of VCSEL 100 (and hence a layer thickness and refractive index) may require repeatability in manufacturing (e.g., to a few tenths of a percent in the layer thicknesses). The layer thickness and the refractive index of a reflector pair near active region 110 (e.g., near a center of the laser cavity) more critically affects the lasing wavelength as compared to reflector pairs further from active region 110. Thus, in some implementations, in order to maintain consistent control of the growth thickness, N reflector pairs (e.g., N reflector pairs closest to substrate layer 104) may include strain compensating low-index layers 142, while M reflector pairs nearest to active region 110 may include low-index layers 136 (without P). In some implementations, the number of M reflector pairs (e.g., the number of reflector pairs in bottom mirror 108 that include low-index layer 136 rather than strain compensating low-index layer 142) may be in a range from 3 reflector pairs to 8 reflector pairs.

Additionally, or alternatively, the M reflector pairs may include low-index layers 136 in order to maximize thermal conductivity near active region 110. For example, since thermal conductivity may be more critical to maximize near active region 110 (e.g., as compared to near substrate layer 104), the M reflector pairs may include low-index layers 136 (e.g., rather than strain compensating low-index layers 142) since inclusion of a strain compensating low-index layer 142 in a given reflector pair may reduce thermal conductivity (e.g., as compared to a reflector pair including a low-index layer 136).

Notably, in some implementations, VCSEL 100 may include strain compensating low-index layers 142 only (e.g., rather than strain compensating high-index layers or a combination of strain compensating low-index layers 142 and strain compensating high-index layers). For example, the addition of P to an AlGaAs layer (e.g., forming an $Al_xGa_{(1-x)}As_{(1-y)}P_y$ layer, where y is less than or equal to approximately 0.10) will lower a refractive index of the layer (e.g., as compared to an $Al_xGa_{(1-x)}As$ layer). Thus, in order to maintain a suitable level of reflectivity and/or reduce a number of required reflector pairs in a reflector (e.g., bottom mirror 108), P may be included in high aluminum content (i.e., low-index) layers only.

In some implementations, in order to increase thermal conductivity and/or reduce a refractive index of strain compensating low-index layers 142, an amount of Ga may be less than that included in a low-index layer 136 (i.e., strain compensating low-index layer 142 may have a higher Al content than low-index layer 136). For example, a mole fraction of Ga in strain compensating low-index layer 142 may be in a range from approximately 5% to approximately 10% (e.g., x = 0.95 to 0.90), may be less than or equal to approximately 20% (e.g., x = 0.80), and/or the like. Such Ga content in strain compensating low-index layer 142 may be sufficient to impede the lateral oxidation from an edge of a VCSEL 100 die with less increase in the thermal conductivity than additional Ga would cause. Further, in the case of MOCVD growth, excessive background Carbon doping may be avoided due to the inclusion of some Ga (e.g., as compared to eliminating Ga and including additional Al) which may provide compensation for n-type doping intended for strain compensating low-index layer 142.

In some implementations, in order to address electrical and growth considerations, graded regions 140 adjacent to a given strain compensating low-index layer 142 (e.g., graded regions 140 above and below the given strain compensating low-index layer 142) may include a gradual change in a P mole fraction (e.g., such that the P content of graded region 140 gradually decreases within graded region 140 in a direction away from strain compensating low-index layer 142). In some implementations, such grading may help to reduce the electrical resistance of the DBR (e.g., bottom mirror 108, top mirror 114).

In some implementations, compensation of compressive strain by design of epitaxial layers 106 may be advantageous as compared to compensation by adding other materials to VCSEL 100 (e.g., by including one or more additional layers in VCSEL 100). For example, strain compensation through the above described design of epitaxial layers 106 may be easier to maintain over a wide temperature range since a coefficient of thermal expansion of AlGaAsP strain compensating low-index layers 142 is closer to that of a GaAs substrate layer 104 than a coefficient of thermal expansion of another material that may be included in VCSEL 100 in order to provide strain compensation, such as a dielectric material (e.g., SiNx), a metallic material (e.g., Gold), and/or the like. Use of dielectric or metal (e.g., SiNx, $SiO_2$, Pt, and/or the like) with a different coefficient of thermal expansion from GaAs may exactly compensate for the strain at a particular temperature. However, the temperature may vary by several hundred degrees Kelvin during wafer processing.

In some implementations, strain compensating low-index layers 142 may be designed to eliminate compressive strain of epitaxial layers 106 such that a wafer of VCSELs 100 experiences no bowing. Alternatively, strain compensating low-index layers 142 may be designed such that epitaxial layers 106 have a particular amount of strain in order to cause a wafer of VCSELs 100 to experience a particular amount of bowing (e.g., such that a small residual strain remains). Such a design may be advantageous so that bowing is always in a same direction, to compensate for strain of other layers of VCSEL 100 that are part of a final wafer and device structure, and/or the like. Having a same resultant shape among VCSEL wafers (e.g., a concave bowing rather than convex bowing, convex bowing rather than concave bowing) may be beneficial when, for example, implementing a process for placing a VCSEL wafer on a vacuum-chuck and pulling the VCSEL wafer to a surface, when using automated handling tools associated with wafer testing, and/or the like. In this way, epitaxial layers 106 of VCSEL 100 may be designed in order to control compressive strain introduced by epitaxial layers 106, thereby controlling an amount of bowing experienced by a thinned wafer of VCSELs 100.

Notably, a conventional VCSEL does not include strain compensating layers 142 in epitaxial layers of the conventional VCSEL. For example, with reference to Fig. 2, conventional epitaxial layers include reflector pairs comprising low-index layers and high-index layers only, and do not include reflector pairs comprising strain compensating low-index layers.

The number and arrangement of layers shown in Figs. 1A-1C are provided as an example. In practice, VCSEL 100 may include additional layers, fewer layers, different layers, differently arranged layers, layers with different thicknesses or relative thicknesses, and/or the like, than those shown in Figs. 1A-1C. Further, while the VCSEL design associated with Figs. 1A-1C shows cross sections for a single emitter, this design may be applied to arrays of emitters (e.g., with or without a common anode and substrate-side cathode). Additionally, or alternatively, a set of layers (e.g., one or more layers) of VCSEL 100 may perform one or more functions described as being performed by another set of layers of VCSEL 100.

In some implementations, strain compensation may be achieved by tensile straining a set of high-index layers 138 (e.g., rather than a set of low-index layers 142 or in addition to a set of low-index layers 142). For example, Phosphorous (P) may be included in the set of high-index layers 138 in order to form a set of AlGaAsP high-index layers 138 (e.g., rather than AlGaAs). Here, the inclusion of P may at least partially compensate for compressive strain of low-index layers 136, which have a comparatively higher Al content.

In some implementations, with the inclusion of P in a high-index layer 138, the Al content of the high-index layer 138 may be decreased in order to provide a similar bandgap (e.g., a similar absorption edge and refractive index) as a high-index layer 138 that does not include P (e.g., an AlGaAs high-index layer 138). However, the bandgap should be approximately equal to or greater than a minimum for the AlGaAs high-index layer 138 in order to, for example, prevent the absorption edge from interfering with laser operation (e.g., at high temperatures) and/or from affecting long-term reliability.

In some implementations, decreasing the Al content of a high-index layer 138 including P may help to maintain a same refractive index contrast as that of a VCSEL design without strain compensation. However, due to the limitation on the absorption edge, the refractive index contrast should not be made higher than that of an AlGaAs-based design when exclusively adding P the set of high-index layers 138. Conversely, when achieving strain compensation by tensile straining low-index layers to form low-index layers 142 in the manner described above, the refractive index contrast may be higher than for a VCSEL design without strain compensation, which may allow a number of mirror pairs to be reduced.

Some implementations described herein provide VCSEL designs for controlling (e.g., reducing, controlling, and/or the like) wafer bowing of a thinned VCSEL wafer, thereby reducing fragility of the VCSEL wafer and/or making the thinned VCSEL wafer easier to handle, transport, test, and/or the like, with a reduced risk of breakage (e.g., as compared to a VCSEL wafer with a conventional VCSEL design).

The foregoing disclosure provides illustration and description, but is not intended to be exhaustive or to limit the implementations to the precise form disclosed. Modifications and variations are possible in light of the above disclosure or may be acquired from practice of the implementations.

Even though particular combinations of features are recited in the claims and/or disclosed in the specification, these combinations are not intended to limit the disclosure of possible implementations. In fact, many of these features may be combined in ways not specifically recited in the claims and/or disclosed in the specification. Although each dependent claim listed below may directly depend on only one claim, the disclosure of possible implementations includes each dependent claim in combination with every other claim in the claim set.

No element, act, or instruction used herein should be construed as critical or essential unless explicitly described as such. Also, as used herein, the articles "a" and "an" are intended to include one or more items, and may be used interchangeably with "one or more." Furthermore, as used herein, the term "set" is intended to include one or more items (e.g., related items, unrelated items, a combination of related items, and unrelated items, etc.), and may be used interchangeably with "one or more." Where only one item is intended, the term "one" or similar language is used. Also, as used herein, the terms "has," "have," "having," or the like are intended to be open-ended terms. Further, the phrase "based on" is intended to mean "based, at least in part, on" unless explicitly stated otherwise.

The present invention may be defined by way of the following clauses. It will be understood that the features recited are interchangeable defined by the following clauses and their dependencies. That is, the features of the clauses may be combined to define the present invention.

**CLAUSES:**

1. A vertical-cavity surface-emitting laser (VCSEL) wafer, comprising:

   a substrate layer; and
   epitaxial layers on the substrate layer,
   wherein the epitaxial layers include an active region, a first mirror, and a second mirror,

      wherein the active region is between the first mirror and the second mirror, and
      wherein the second mirror includes a set of reflector pairs, each reflector pair including a respective strain compensating low-index layer associated with controlling bowing of the VCSEL wafer after thinning.

2. The VCSEL wafer of clause 1, wherein the first mirror is a p-doped reflector and the second mirror is an n-doped reflector.

3. The VCSEL wafer of clause 1, wherein the set of reflector pairs is a first set of reflector pairs, and

   wherein the second mirror further includes a second set of reflector pairs, each reflector pair of the second set including a respective low-index layer that is not associated with controlling bowing of the VCSEL wafer after thinning,
   wherein the second set of reflector pairs is between the active region and the first set of reflector pairs.

4. The VCSEL wafer of clause 3, wherein the second set of reflector pairs includes eight or fewer reflector pairs.

5. The VCSEL wafer of clause 1, wherein the second mirror is between the first mirror and the substrate layer.

6. The VCSEL wafer of clause 1, wherein the substrate layer is a Gallium-Arsenide (GaAs) layer and the respective strain compensating low-index layers are Aluminum-Gallium-Arsenic-Phosphide (AlGaAsP) layers.

7. The VCSEL wafer of clause 6, wherein a Phosphorous mole fraction of each of the respective strain compensating low-index layers is less than or equal to approximately 10%.

8. The VCSEL wafer of clause 6, wherein a Gallium mole fraction of each of the respective strain compensating low-index layers is less than or equal to approximately 20%.

9. The VCSEL wafer of clause 1, wherein each of the set of reflector pairs includes a graded region adjacent to the respective strain low-index compensating layer,
wherein a Phosphorous mole faction of the graded region decreases within the graded region in a direction away from the respective strain compensating low-index layer.

10. The VCSEL wafer of clause 1, wherein a lattice constant of the substrate layer matches a lattice constant of the epitaxial layers.

11. A surface emitting laser, comprising:

a substrate layer; and
epitaxial layers on the substrate layer,
wherein the epitaxial layers include an active region, a first mirror, and a second mirror,

wherein the active region is between the first mirror and the second mirror, and
wherein the second mirror includes a set of reflector pairs, each reflector pair including a respective strain compensating layer associated with controlling bowing of a wafer, including the surface emitting laser, after thinning.

12. The surface emitting laser of clause 11, wherein the first mirror is a p-doped reflector and the second mirror is an n-doped reflector.

13. The surface emitting laser of clause 11, wherein the strain compensating layer is a low-index layer, and
wherein each of the set of reflector pairs further includes a high-index layer.

14. The surface emitting laser of clause 11, wherein the set of reflector pairs is a first set of reflector pairs, the respective strain compensating layers are low-index layers, and
wherein the second mirror further includes a second set of reflector pairs, each reflector pair of the second set including a respective low-index layer that is not associated with controlling bowing of the wafer after thinning,
wherein the second set of reflector pairs is between the active region and the first set of reflector pairs.

15. The surface emitting laser of clause 14, wherein the second set of reflector pairs includes at least three reflector pairs.

16. The surface emitting laser of clause 11, wherein the respective strain compensating layers are Aluminum-Gallium-Arsenic-Phosphide (AlGaAsP) layers,

wherein a Phosphorous mole fraction of the respective strain compensating layers is less than or equal to approximately 10%, and
wherein a Gallium mole fraction of each of the respective strain compensating layers is less than or equal to approximately 20%.

17. The surface emitting laser of clause 11, wherein each of the set of reflector pairs includes a graded region adjacent to the respective strain compensating layer,
wherein a Phosphorous mole faction of the graded region decreases in a direction away from the respective strain compensating layer.

18. A vertical-cavity surface-emitting laser (VCSEL), comprising:
a set of epitaxial layers comprising:

an active region;
a first mirror on a first side of the active region; and
a second mirror on a second side of the active region,

wherein the second side of the active region is opposite to the first side of the active region, and
wherein the second mirror includes a set of strain compensating layers associated with controlling bowing of a wafer, including the VCSEL, after thinning of the wafer.

19. The VCSEL of clause 18, wherein the first mirror is a p-doped reflector and the second mirror is an n-doped reflector.

20. The VCSEL of clause 18, wherein the set of strain compensating layers is a set of low-index layers.

## Claims

1. A vertical-cavity surface-emitting laser (VCSEL) wafer, comprising:

   a substrate layer; and
   epitaxial layers on the substrate layer,
   wherein the epitaxial layers include an active region, a first mirror, and a second mirror,

      wherein the active region is between the first mirror and the second mirror, and
      wherein the second mirror includes a set of reflector pairs, each reflector pair including a respective strain compensating low-index layer associated with controlling bowing of the VCSEL wafer after thinning.

2. The VCSEL wafer of claim 1, wherein the set of reflector pairs is a first set of reflector pairs, and
   wherein the second mirror further includes a second set of reflector pairs, each reflector pair of the second set including a respective low-index layer that is not associated with controlling bowing of the VCSEL wafer after thinning,
   wherein the second set of reflector pairs is between the active region and the first set of reflector pairs.

3. The VCSEL wafer of claim 2, wherein the second set of reflector pairs includes eight or fewer reflector pairs.

4. The VCSEL wafer of claim 1, wherein the second mirror is between the first mirror and the substrate layer.

5. The VCSEL wafer of claim 1, wherein the substrate layer is a Gallium-Arsenide (GaAs) layer and the respective strain compensating low-index layers are Aluminum-Gallium-Arsenic-Phosphide (AlGaAsP) layers.

6. The VCSEL wafer of claim 5, wherein a Phosphorous mole fraction of each of the respective strain compensating low-index layers is less than or equal to approximately 10%, and
   wherein a Gallium mole fraction of each of the respective strain compensating low-index layers is less than or equal to approximately 20%.

7. The VCSEL wafer of claim 1, wherein a lattice constant of the substrate layer matches a lattice constant of the epitaxial layers.

8. A surface emitting laser, comprising:

   a substrate layer; and
   epitaxial layers on the substrate layer,
   wherein the epitaxial layers include an active region, a first mirror, and a second mirror,

      wherein the active region is between the first mirror and the second mirror, and
      wherein the second mirror includes a set of reflector pairs, each reflector pair including a respective strain compensating layer associated with controlling bowing of a wafer, including the surface emitting laser, after thinning.

9. The surface emitting laser of claim 8, wherein the strain compensating layer is a low-index layer, and wherein each of the set of reflector pairs further includes a high-index layer.

10. The surface emitting laser of claim 8, wherein the set of reflector pairs is a first set of reflector pairs, the respective strain compensating layers are low-index layers, and
    wherein the second mirror further includes a second set of reflector pairs, each reflector pair of the second set including a respective low-index layer that is not associated with controlling bowing of the wafer after thinning,
    wherein the second set of reflector pairs is between the active region and the first set of reflector pairs.

11. The surface emitting laser of claim 10, wherein the second set of reflector pairs includes at least three reflector pairs.

12. The surface emitting laser of claim 8, wherein the respective strain compensating layers are Aluminum-Gallium-Arsenic-Phosphide (AlGaAsP) layers,

    wherein a Phosphorous mole fraction of the respective strain compensating layers is less than or equal to approximately 10%, and
    wherein a Gallium mole fraction of each of the respective strain compensating layers is less than or equal to approximately 20%.

13. The VCSEL wafer of claim 1 or the surface emitting laser of claim 8, wherein each of the set of reflector pairs includes a graded region adjacent to the respective strain compensating layer,
    wherein a Phosphorous mole faction of the graded region decreases in a direction away from the respective strain compensating layer.

**14.** A vertical-cavity surface-emitting laser (VCSEL), comprising:
a set of epitaxial layers comprising:

an active region;
a first mirror on a first side of the active region; and
a second mirror on a second side of the active region,

wherein the second side of the active region is opposite to the first side of the active region, and
wherein the second mirror includes a set of strain compensating layers associated with controlling bowing of a wafer, including the VCSEL, after thinning of the wafer.

**15.** The VCSEL of claim 1 or claim 14 or the surface emitting laser of claim 8, wherein the first mirror is a p-doped reflector and the second mirror is an n-doped reflector.

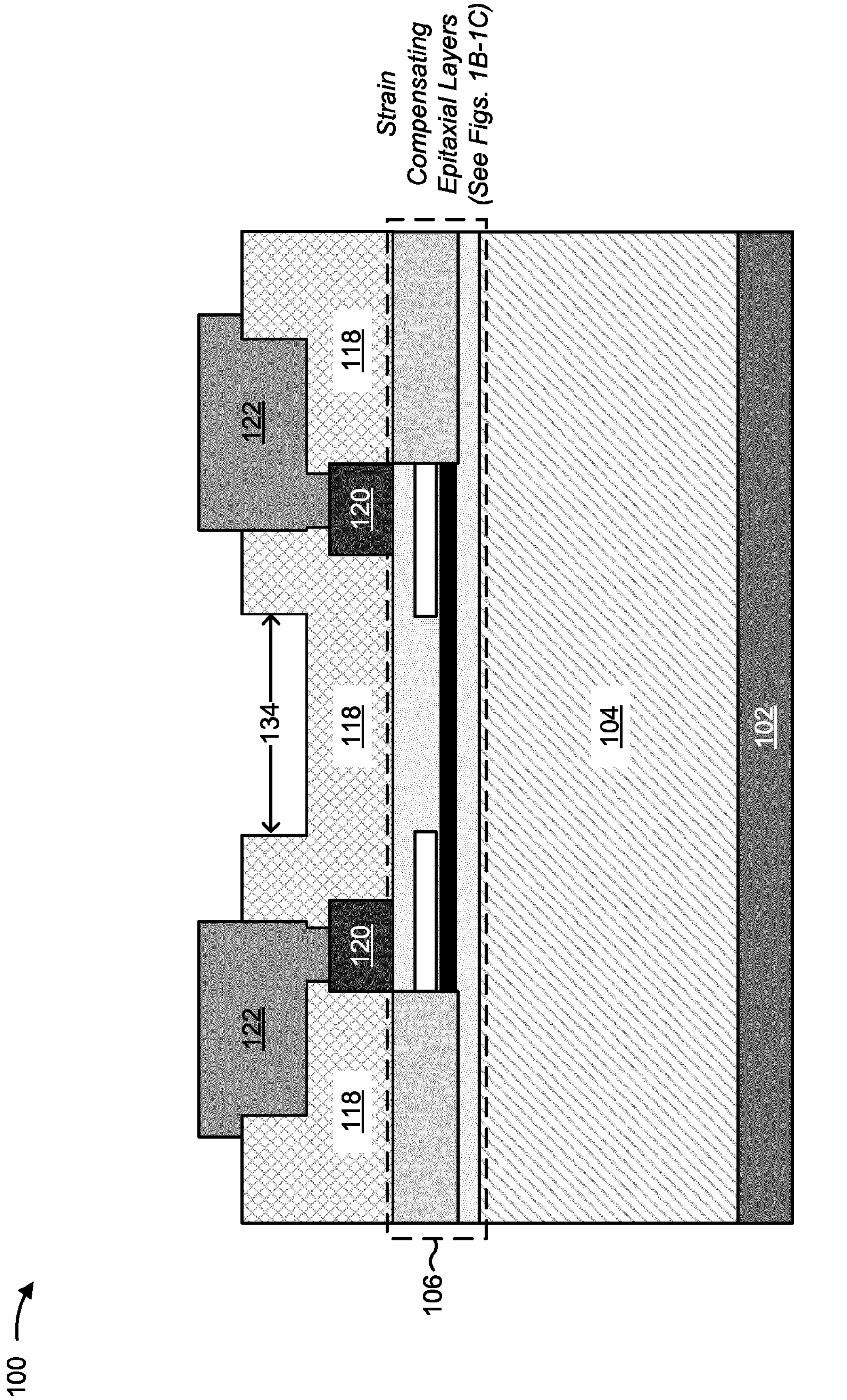
Strain
Compensating
Epitaxial Layers
(See Figs. 1B-1C)
122
120
118
134
118
120
122
118
104
102
106
100

FIG. 1A

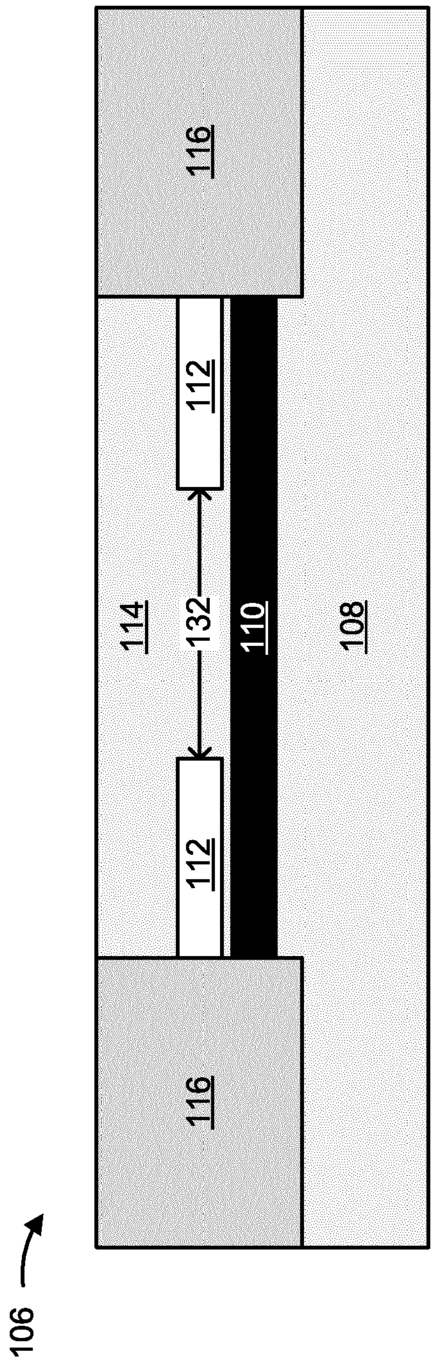


FIG. 1B

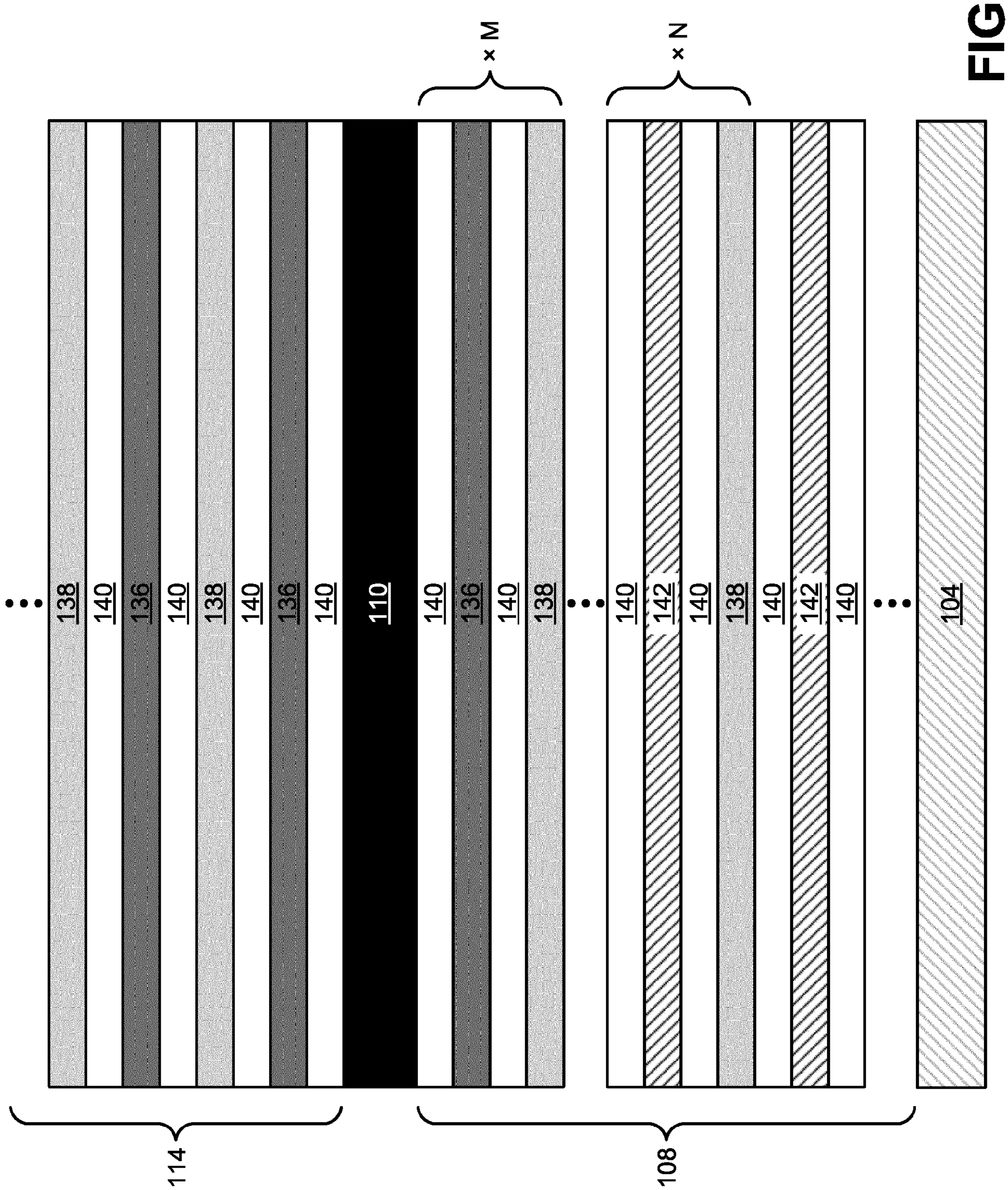
138
140
136
140
138
140
136
140
110
140
136
140
138
140
142
140
138
140
142
140
104
× M
× N
114
108

FIG. 1C

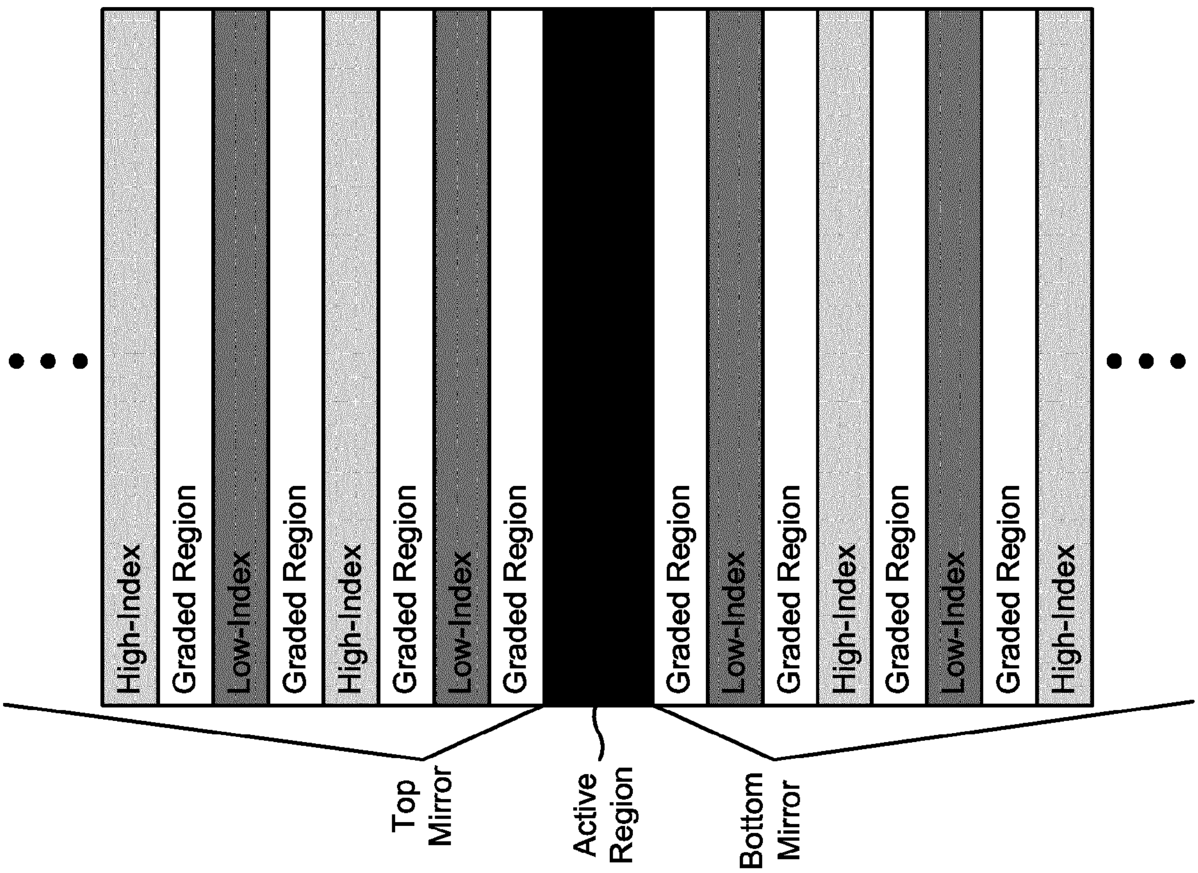


FIG. 2
*(Prior Art)*

Europäisches Patentamt
European Patent Office
Office européen des brevets

# EUROPEAN SEARCH REPORT

Application Number
EP 18 16 5352

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/026555 A1 (TAKEUCHI TETSUYA [JP]) 3 February 2011 (2011-02-03) | 1,2,4, 7-10,14, 15 | INV. H01S5/02 H01S5/183 H01S5/343 H01S5/42 H01S5/20 |
| Y | * paragraph [0039] - paragraph [0045] * * paragraph [0064] * * paragraph [0076] - paragraph [0078] * * paragraph [0099] * * paragraph [0110] - paragraph [0147]; figures 1,2; example 1 * * paragraph [0189] - paragraph [0204]; figure 9; example 4 * * paragraph [0157] - paragraph [0161]; figure 6 * ----- | 3,11 | |
| X | JP 2006 310534 A (NEC CORP) 9 November 2006 (2006-11-09) | 1,2, 4-10, 12-15 | |
| Y | * abstract * * paragraph [0091] - paragraph [0111]; figures 6,7,8 * * paragraph [0010] - paragraph [0012] * * paragraph [0026] * * paragraph [0042] * * paragraph [0071] * ----- | 3,11 | |
| A | US 6 597 017 B1 (SEKO YASUJI [JP] ET AL) 22 July 2003 (2003-07-22) * column 9 - column 11; figures 1,4 * ----- | 1-15 | |

TECHNICAL FIELDS SEARCHED (IPC)

H01S

The present search report has been drawn up for all claims

| Place of search | Date of completion of the search | Examiner |
|---|---|---|
| Munich | 14 November 2018 | Hervé, Denis |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 18 16 5352

This annex lists the patent family members relating to the patent documents cited in the above-mentioned European search report. The members are as contained in the European Patent Office EDP file on
The European Patent Office is in no way liable for these particulars which are merely given for the purpose of information.

14-11-2018

| Patent document cited in search report | Publication date | Patent family member(s) | Publication date |
|---|---|---|---|
| US 2011026555 A1 | 03-02-2011 | JP 5489576 B2 | 14-05-2014 |
| | | JP 2011035115 A | 17-02-2011 |
| | | US 2011026555 A1 | 03-02-2011 |
| JP 2006310534 A | 09-11-2006 | NONE | |
| US 6597017 B1 | 22-07-2003 | JP 2000349393 A | 15-12-2000 |
| | | US 6597017 B1 | 22-07-2003 |

EPO FORM P0459

For more details about this annex : see Official Journal of the European Patent Office, No. 12/82